# EUROPÄISCHE PATENTSCHRIFT

(11) **EP 0 860 011 B1**
(45) Veröffentlichungstag und Bekanntmachung des Hinweises auf die Patenterteilung: **09.06.1999**
(21) Anmeldenummer: 96945974.2
(22) Anmeldetag: 04.11.1996
(51) Int. Cl.: G11C 29/00, G11C 16/06

(54) **VERFAHREN UND VORRICHTUNG ZUM SELBSTTÄTIGEN ERMITTELN DER NÖTIGEN HOCHSPANNUNG ZUM PROGRAMMIEREN/LÖSCHEN EINES EEPROMS**
METHOD AND DEVICE FOR AUTOMATIC DETERMINATION OF THE REQUIRED HIGH VOLTAGE FOR PROGRAMMING/ERASING AN EEPROM
PROCEDE ET DISPOSITIF DE DETERMINATION AUTOMATIQUE DE LA HAUTE TENSION REQUISE POUR PROGRAMMER/EFFACER UNE MEMOIRE EEPROM

(30) Priorität: 10.11.1995 DE 19542029
(43) Veröffentlichungstag der Anmeldung: 26.08.1998
(73) Patentinhaber: SIEMENS AKTIENGESELLSCHAFT, 80333 München (DE)
(72) Erfinder: SEDLAK, Holger, D-81541 München (DE); VIEHMANN, Hans-Heinrich, D-81739 München (DE)
(86) Internationale Anmeldenummer: DE9602099
(87) Internationale Veröffentlichungsnummer: WO9717704

(56) Entgegenhaltungen:
- EP-A- 0 708 450
- WO-A-95/07536
- PATENT ABSTRACTS OF JAPAN vol. 096, no. 001, 31.Januar 1996 & JP 07 249294 A (TOSHIBA CORP), 26.September 1995,

## Beschreibung

Bei MOS-Feldeffekttransistoren sind zu beiden Seiten einer isoliert über einem Substrat angeordneten Gateelektrode Dotierungsgebiete im Substrat vorhanden, die als Source- und Drain-Gebiete bezeichnet werden. Durch Anlegen einer Spannung zwischen der Gateelektrode und dem Substrat werden beispielsweise bei einem Feldeffekttransistor vom Anreicherungs- oder Enhancement-Typ Ladungsträger aus dem Substrat unter der Gateelektrode angereichert. Durch Anlegen einer Spannung zwischen dem Drain- und dem Source-Gebiet werden weitere Ladungsträger aus dem Source-Gebiet in dieses angereicherte Gebiet injiziert, so daß sich unter der Gateelektrode zwischen dem Source- und dem Drain-Gebiet ein leitender Kanal bildet, dessen Leitfähigkeit durch die Spannung an der Gateelektrode gesteuert werden kann.

Allerdings muß zur Ausbildung eines leitenden Kanals eine Spannung zwischen die Gateelekrode und das Substrat angelegt werden, die einen bestimmten, technologieabhängigen Minimalwert hat, der als Einsatz- oder Thresholdspannung bezeichnet wird.

Elektrisch löschbare Festwertspeicherzellen vom EEPROM- oder Flash-Typ sind prinzipiell wie MOS-Feldeffekttransistoren aufgebaut, haben jedoch zwischen ihrer Gateelektrode, die hier als Steuerelektrode bezeichnet wird, und dem Substrat eine weitere Elektrode, die vollständig von nicht-leitendem Material umgeben ist - also völlig isoliert ist - und als Floating-Gate bezeichnet wird. Durch Aufbringen einer Ladung auf dieses Floating-Gate läßt sich die Einsatz spannung des eine Speicherzelle bildenden Transistors verschieben.

Das Aufbringen von Ladungen auf das Floating-Gate wird als Programmieren und das Entfernen der Ladungen als Löschen der Speicherzelle bezeichnet. Üblicherweise wird durch das Programmieren bewirkt, daß die Einsatzspannung zu geringeren Werten hin verschoben wird, so daß der die Zelle bildende Transistor meist auch ohne Anlegen einer Spannung an die Steuerelektrode leitet.

Zum Feststellen, ob eine Zelle programmiert ist oder nicht, ob sie also mit einer logischen "1" oder "0" beschrieben ist, wird eine Spannung, die sogenannte Lesespannung, an die Steuerelektrode angelegt, die etwa zwischen den Einsatzspannungen einer programmierten und einer gelöschten Zelle liegt. Abhängig davon, ob ein Strom durch die Zelle fließt kann dann ihr logischer Zustand festgestellt werden.

Das Programmieren oder Löschen einer EEPROM- oder Flash-Zelle erfolgt durch einen vom Substrat zum Floating-Gate bzw. umgekehrt fließenden Tunnelstrom. Hierzu muß den Ladungsträgern genügend Energie zugeführt werden, was durch Anlegen einer hohen Spannung von derzeit etwa 15V zwischen die Steuerelektrode und das Substrat und die Ausbildung einer extrem dünnen Isolierschicht zwischen dem Floating-Gate und dem Substrat, so daß dort eine sehr hohe Feldstärke auftritt, erfolgt.

Bei einem n-Kanal-Transistor werden zum Programmieren positive Ladungsträger auf das Floating-Gate aufgebracht, was bei Verwendung einer heute üblichen positiven Hochspannung bedeutet, daß diese an das Drain-Gebiet angelegt werden muß, während an die Steuerelektrode 0V angelegt werden. Entsprechend wird dann zum Löschen der Zelle die Hochspannung an die Steuerelektrode und an das Drain-Gebiet 0V angelegt, um die Ladungsträger wieder von dem Floating -Gate zu entfernen.

Es ist grundsätzlich eine bestimmte Mindesthochspannung nötig, um den Tunnelstrom einsetzen zu lassen. Der Grad der Programmierung oder des Löschens hängt aber auch noch von der tatsächlichen Höhe der Hochspannung und von der Zeitdauer, während der sie anliegt, ab. Der prinzipielle Verlauf der Einsatzspannung Uth - und damit des Ladungszustandes des Floating-Gates - von der Höhe der Hochspannung Vpp ist in Figur 4 mit durchgezogenen Linien dargestellt. Es ist zu sehen, daß mit zunehmender Hochspannung beim Löschen die Einsatzspannung der Zelle steigt, während sie beim Programmieren sinkt. Die Kurven verlaufen bei einer idealen Zelle symmetrisch zueinander, so daß die Einsatzspannung am Schnittpunkt der beiden Kurven als Lesespannung UL gewählt wird, da dann zu beiden Einsatzspannungen derselbe Abstand und somit auch derselbe Störabstand besteht.

Für die Wahl der Höhe der Hochspannung besteht nun einerseits der Wunsch nach einem möglichst großen Störabstand und außerdem sollen alle Zellen eindeutig programmiert oder gelöscht sein, was eine hohe Hochspannung bedeutet, andererseits soll der Aufwand für den Hochspannungsgenerator, der üblicherweise mit einer Ladungspumpe gebildet wird, möglichst klein gehalten werden, was bedeutet, daß die Hochspannung möglichst gering gehalten wird. Es wird also normalerweise ein Wert für die Hochspannung gewählt werden, der gerade noch eine eindeutige Programmierung oder ein Löschen zuläßt.

Aufgrund von technologiebedingten Fertigungstoleranzen können aber von Wafer zu Wafer, auf einem Wafer von Chip zu Chip und auf einem Chip von Zelle zu Zelle Unterschiede im Verlauf der Kurven, die die Abhängigkeit der Einsatzspannung Uth von der Hochspannung Vpp beim Programmieren und Löschen zeigen, auftreten, was zu fehlerhaften Speichern führen kann. In Figur 4 sind strichliert eine weitere Programmier- und Löschkurve dargestellt, wie sie sich aufgrund solcher Schwankungen ergeben können. Wie zu erkennen ist, würde bei einer Zelle mit dem strichliert dargestellten Verlauf der Kurven bei einer gegebenen Lesespannung UL und einer Hochspannung, wie sie aus den durchgezogen dargestellten Kurven als günstig ermittelt wurde, kein detektierbarer Löschvorgang stattfinden.

Die WO 95/07536 offenbart ein Verfahren zum Einstellen einer Programmierspannung am Drain-Anschluß einer Flash-EPROM-Speicherzelle sowie einen Speicher mit Mitteln für ein solches Einstellen derart, daß sich die Schwellspannungen aller Speicherzellen einer Zeile innerhalb eines vorgegebenen Fensters befinden; ist dies nicht möglich, so wird eine Fehlermeldung ausgegeben.

Die Aufgabe vorliegender Erfindung ist also, ein Verfahren und eine Vorrichtung anzugeben mittels dem oder der bei einem elektrisch lösch- und programmierbaren Festwerthalbleiterspeicher eine eindeutige Programmierung und und ein eindeutiges Löschen möglich und weitgehend unabhängig von technologiebedingten Schwankungen der Abhängigkeit der Einsatzspannung von der Hochspannung ist.

Die Aufgabe wird durch Verfahren gemäß den Ansprüchen 1 und 3 sowie einer Vorrichtung gemäß Anspruch 5 gelöst.

Durch die erfindungsgemäßen Verfahren und die Vorrichtung zum Durchführen der Verfahren wird sukzessive für jeden Speicher die für ihn günstigste Hochspannung ermittelt und in einem Festwertspeicher nicht-flüchtig abgelegt, um für alle Programmier- und Löschvorgänge von der Steuereinheit ausgelesen und verwendet werden zu können.

Es kann vorgesehen werden, die Hochspannung nur beim allerersten Einschalten des Speichers zu ermitteln und abzuspeichern, es ist aber auch möglich, die Steuereinheit so auszubilden, daß dieser Vorgang bei jedem Einschalten erfolgt. In bestimmten Fällen, beispielsweise in sich stark ändernder Umgebung, kann es auch vorteilhaft sein, eine Ermittlung der günstigsten Hochspannung in regelmäßigen Abständen durchzuführen.

Sukzessive Ermittlung bedeutet hierbei, daß die an den Speicher zum Programmieren oder Löschen anzulegende Hochspannung in Stufen zwischen einem Minimal- und einem Maximalwert verändert und das Programmier- bzw. Löschergebnis mit einer festen, vorgegebenen Lesespannung geprüft wird, oder daß die Programmierung oder Löschung bei einer vorgegebenen Hochspannung, die ebenfalls zwischen dem Minimal- und dem Maximalwert - in vorteilhafter Weise den arithmetischen Mittelwert dieser beiden Werte bildend - liegt, und mit unterschiedlichen Lesespannungen getestet wird.

Als Minimalwert der Hochspannung wird vorteilhafterweise ein Wert genommen, der gleich oder größer als der physikalisch notwendig ist, um den Tunneleffekt bewirken zu können, so daß keine zeitraubenden Programmier- und Löschversuche unternommen werden, die schon grundsätzlich nicht zum Erfolg führen können. Der Maximalwert wird durch den schaltungstechnischen Aufwand der Ladungspumpe zum Erzeugen der Hochspannung begrenzt werden.

Die Lesespannung kann im ersten Fall, wo sie konstant bleibt, denselben Wert aufweisen wie bei jedem "normalen" Lesen aus dem Speicher während des bestimmungsgemäßen Betriebs. Sie kann aber in vorteilhafter Weise auch kritischer eingestellt werden, das heißt näher an der durch den Programmier- oder Löschvorgang eingestellten Einsatzspannung, um somit fehlerhafte Zellen genauer detektieren zu können.

Beim Verfahren gemäß Anspruch 1 müssen zum Ermitteln der nötigen Hochspannung im Bedarfsfall mehrere Lösch- bzw. Programniervorgänge in Kauf genommen werden, wobei hier in bezüglich des Ermittlungsergebnisses vorteilhafter Weise vor jedem Lösch- bzw. Programmiervorgang mit durch die Steuereinheit eingestellter Hochspannung ein Programmier- bzw. Löschvorgang mit maximaler Hochspannung durchgeführt werden kann. Dies erfordert jedoch einen nicht unerheblichen Zeitaufwand.

Das Verfahren gemäß Anspruch 3 ist deutlich schneller, da hier nur ein Programmier- bzw. Löschvorgang durchgeführt wird, während mehrere Lesevorgänge erfolgen, die jedoch prinzipiell wesentlich schneller ablaufen.

In Weiterbildung der Erfindung kann die ermittelte nötige Hochspannung noch um einen fest vorgegebenen Wert erhöht werden, um einen wirklich sicheren Programmier- und Löschvorgang zu gewährleisten.

Die Erfindung soll nachfolgend anhand von Ausführungsbeispielen mit Hilfe von Figuren näher erläutert werden. Dabei zeigen:
Figur 1 ein Prinzipschaltbild einer erfindungsgemäßen Vorrichtung,
Figur 2 ein Flußdiagramm eines ersten erfindungsgemäßen Verfahrens,
Figur 3 ein Flußdiagramm eines zweiten erfindungsgemäßen Verfahrens und
Figur 4 Kurven, die die Abhängigkeit der Einsatzspannung von der Hochspannung beim Löschen bzw. Programmieren einer elektrisch lösch- und programmierbaren nicht-flüchtigen Speicherzelle darstellen.

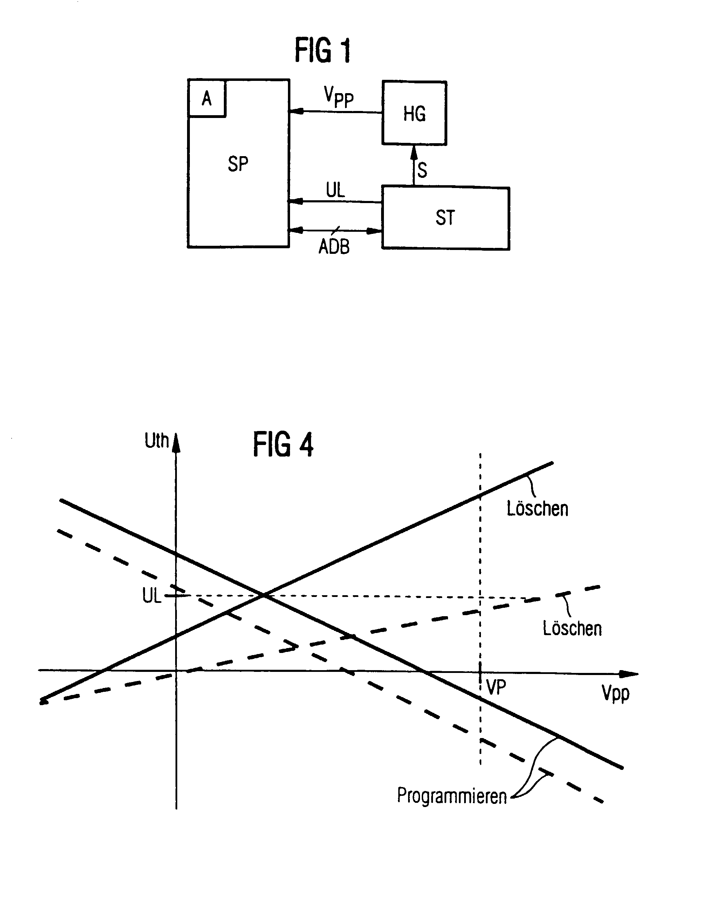

Figur 1 zeigt einen elektrisch programmier- und löschbaren Festwerthalbleiterspeicher SP, der von einer Steuereinheit ST über einen Adreß- und Datenbus ADB angesteuert werden kann. Über eine weitere Leitung ist der Speicher SP von der Steuereinheit ST mit einer Lesespannung UL beaufschlagbar. Zum Programmieren oder Löschen von Daten im Festwertspeicher SP ist eine Hochspannung Vpp erforderlich, die von einem einstellbaren Hochspannungsgenerator HG erzeugt und an den Speicher SP angelegt wird. Der Hochspannungsgenerator HG wird von der Steuereinheit ST mit einem Signal S angesteuert. Das Signal S, das sowohl analog als auch digital sein kann, definiert den Wert der Hochspannung Vpp.

Zum sicheren Programmieren oder Löschen der Speicherzellen des Speichers SP ist ein bestimmter Wert der Hochspannung Vpp nötig. Dieser Wert kann jedoch aufgrund technologiebedingter Schwankungen der Eigenschaften der Speicherzellen von Halbleiterchip zu Halbleiterchip und damit von Speicher zu Speicher unterschiedlich sein. Der Hochspannungsgenerator HG könnte zwar so eingestellt werden, daß er eine maximale Hochspannung liefert, so daß alle Speicher SP sicher programmiert und gelöscht werden können, jedoch würde dies bei den meisten Halbleiterchips, auf denen Speicher SP implementiert sind, zu einem unnötig hohen Leistungsverbrauch führen, da viele der Speicher SP mit einer geringeren Hochspannung Vpp betrieben werden könnten.

Durch ein erfindungsgemäßes Verfahren wird daher für jeden Speicher individuell der günstigste Wert der Hochspannung Vpp, das heißt der Wert, bei dem eine sichere Programmierung und ein sicheres Löschen des Speichers SP möglich ist, ermittelt und in dem Speicher SP in einem Bereich A abgespeichert, so daß er dort von der Steuereinheit ST für jeden weiteren Programmier- und Löschvorgang abgerufen werden kann.

Die Steuereinheit ST kann zwar prinzipiell fest verdrahtet sein, um die noch zu beschreibenden erfindungsgemäßen Verfahren durchzuführen, sie ist jedoch in vorteilhafter Weise mit einem Mikroprozessor mit zugehörigem Programmspeicher gebildet.

Bei einem ersten erfindungsgemäßen Verfahren stellt die Steuereinheit ST mittels des Signals S den einstellbaren Hochspannungsgenerator HG so ein, daß dieser einen ersten Wert der Hochspannung Vpp an den Speicher SP anlegt. Zum Programmieren der Speicherzellen des Speichers SP wird die Hochspannung Vpp an die Drainanschlüsse der Speicherzellen angelegt, während der Steuergateanschluß mit 0 Volt beaufschlagt wird, während zum Löschen der Speicherzellen die Hochspannung Vpp an den Steuergateanschluß der Speicherzellen angelegt wird und der Drainanschluß mit 0 Volt beaufschlagt wird. Der erste Wert der Hochspannung Vpp soll in diesem Beispiel der minimale Wert sein und dann sukzessive erhöht werden. Es ist jedoch genauso möglich, beim maximalen Wert der Hochspannung Vpp zu beginnen und diesen Wert dann sukzessive zu verringern. Die Hochspannung Vpp wird dabei grundsätzlich so lange an die Speicherzellen angelegt, daß bei einem geeigneten Betrag der Hochspannung Vpp eine sichere Programmierung bzw. ein sicheres Löschen gewährleistet ist.

Nach diesem ersten Losch- bzw. Programmiervorgang werden die Zellen von der Steuereinheit ST mit der im normalen Betriebsfall üblichen Lesespannung UL gelesen. Prinzipiell kann jedoch auch eine kritischere Lesespannung gewählt werden, das heißt eine Lesespannung, die näher an den Einsatzspannungen von programmierten bzw. gelöschten Speicherzellen liegt.

Die gelesenen Werte werden dann mit den zuvor geschriebenen, das heißt im Falle einer logischen "1" programmierten bzw. im Fall einer logischen "0" gelöschten Werten verglichen. Wenn der Vergleich ergibt, daß die gelesenen mit den zu schreiben gewünschten Werten übereinstimmen, wird der erste Wert der Hochspannung Vpp in einem Bereich des Speichers SP gespeichert, um für alle weiteren Programmier- und Löschvorgänge von der Steuereinheit ST abgerufen werden zu können.

Vor dem Speichern kann der erste Wert der Hochspannung Vpp noch um einen Sicherheitsbetrag erhöht werden.

Wenn der Vergleich der gelesenen mit den zu schreiben gewünschten Werten negativ ist, wird der Wert der Hochspannung Vpp um einen bestimmten Betrag, gesteuert von der Steuereinheit ST mittels des Signals S, auf einen zweiten Wert erhöht und damit die Speicherzellen des Speichers SP programmiert bzw. gelöscht.

Anschließend werden die gelesenen mit den zu schreiben gewünschten Werten wieder verglichen und bei einem positiven Vergleich der nunmehr zweite Wert der Hochspannung Vpp, eventuell um einen Sicherheitsbetrag erhöht, im Speicher SP abgespeichert.

Verläuft der Vergleich wieder negativ, so wird die Hochspannung Vpp nochmals um einen Betrag erhöht. Dieses Verfahren läuft so lange, bis entweder alle Zellen als gelöscht oder programmiert erkannt sind oder die Hochspannung Vpp nicht weiter erhöht werden kann und der Speicher SP somit als fehlerhaft erkannt ist.

In vorteilhafter Weiterbildung dieses Verfahren kann vor jedem Erhöhen der Hochspannung Vpp im Falle des Löschens des Speichers SP eine Programmierung aller Zellen mit maximaler Hochspannung erfolgen und in gleicher Weise beim Programmieren des Speichers SP ein Löschen aller Zellen mit maximaler Hochspannung erfolgen. Dadurch wird sichergestellt, daß vor jedem Anlegen eines neuen Werts der Hochspannung Vpp dieselben Bedingungen herrschen.

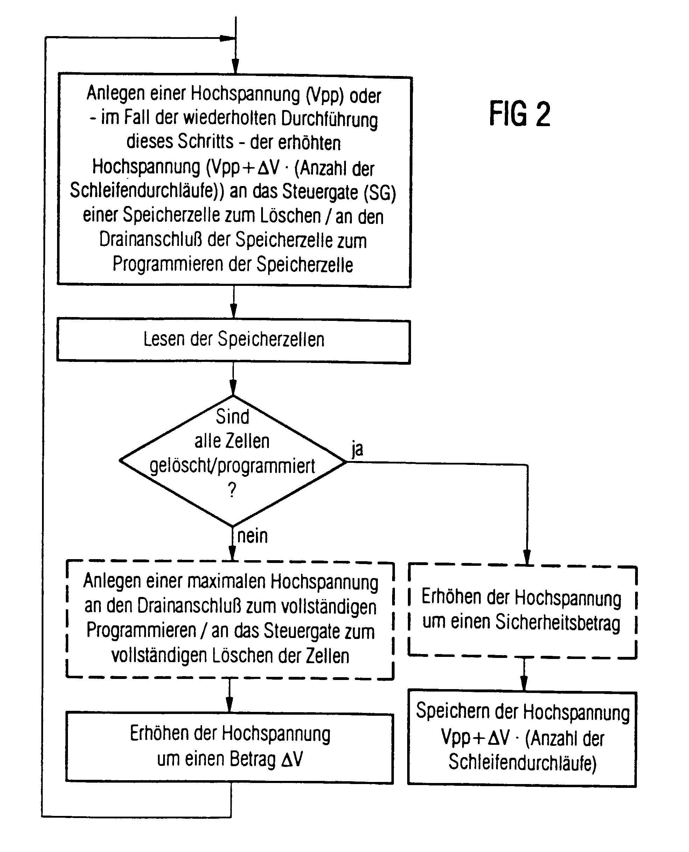

Der Ablauf dieses ersten erfindungsgemäßen Verfahrens ist als Flußdiagramm in Figur 2 dargestellt. Optionale Verfahrensschritte, die aber vorteilhafte Weiterbildungen betreffen, sind dabei mit einem strichliert dargestellten Rahmen versehen.

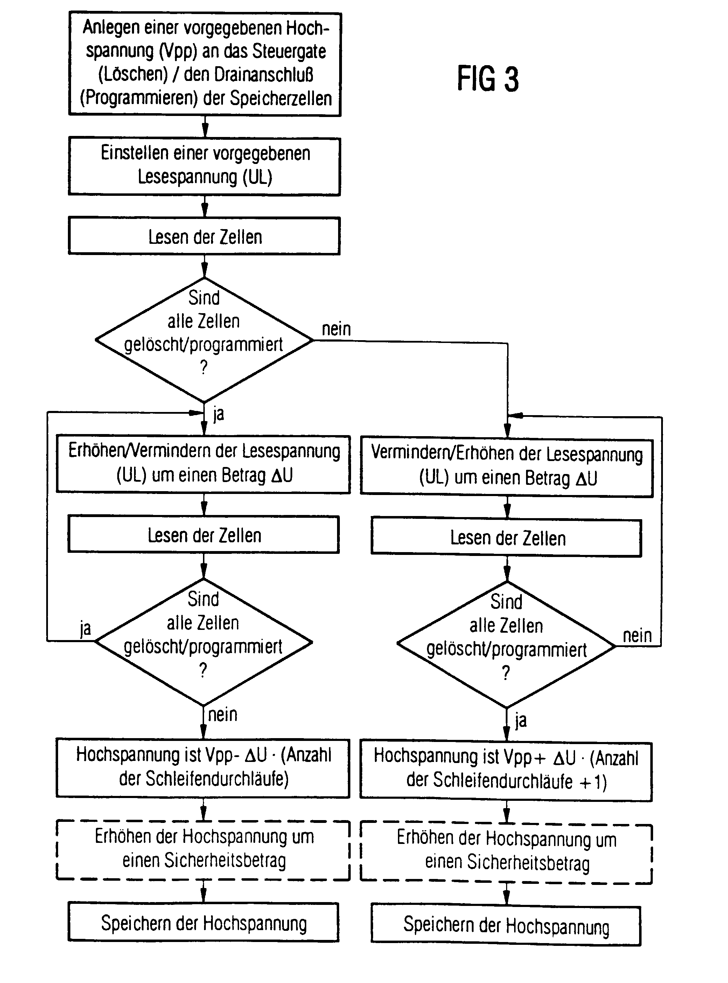

In Figur 3 ist in gleicher Weise das Flußdiagramm eines weiteren erfindungsgemäßen Verfahrens dargestellt. Auch hier wird zunächst eine Hochspannung Vpp an das Steuergate zum Löschen bzw. an den Drainanschluß zum Programmieren der Speicherzellen des Speichers SP angelegt. Der Wert der Hochspannung Vpp ist in diesem Fall jedoch fest vorgegeben und berechnet sich in vorteilhafter Weise als arithmetischer Mittelwert der minimal und maximal einstellbaren Werte des Hochspannungsgenerators HG.

Anschließend wird von der Steuereinheit ST eine vorgegebene Lesespannung UL eingestellt und dann mittels dieser Lesespannung Zellen gelesen.

In einem anschließenden Test wird geprüft, ob die Zellen bei dieser vorgegebenen Lesespannung gelöscht bzw. programmiert sind.

Diesem Verfahren liegt die Erkenntnis zugrunde, daß die Frage der sicheren Programmierung bzw. Löschung einer elektrisch programmierten und löschbaren Festwertspeicherzelle bei einer gegebenen Hochspannung Vpp, die natürlich zumindest so groß sein muß, daß überhaupt Ladungen auf das Floating-Gate der Speicherzelle gelangen, auch von der Lage der Lesespannung UL abhängt. Dies ist in Figur 4 verdeutlicht. Ein idealer Verlauf der Kurven, die die Abhängigkeit der Einsatzspannung Uth einer Speicherzelle beim Löschen bzw. Programmieren von der Hochspannung Vpp zeigt, ist mit einer durchgezogenen Linie dargestellt. Die beiden Kurven haben betragsmäßig dieselbe Steigung und die ideale Lesespannung UL ergibt sich aus dem Schnittpuntk der beiden Kurven. Bei einem gegebenen Wert VP der Hochspannung Vpp läßt sich aus Figur 4 der Abstand der Einsatzspannungen Uth von der Lesespannung UL ablesen.

Strichliert ist in Figur 4 eine durch technologiebedingte Schwankungen herbeigeführte nicht-ideale Lage der Kurven dargestellt. Wie zu sehen ist, würde bei der zuvor idealen Lesespannung UL zwar eine programmierte Zelle erkannt werden, jedoch würde eine gelöschte Zelle ebenfalls als programmiert detektiert werden. Würde eine Speicherzelle mit der strichliert dargestellten Charakteristik jedoch mit einer Lesespannung von etwa 0 Volt gelesen werden, so würde sie sicher als gelöscht bzw. programmiert erkannt werden.

Aufgrund dieser Erkenntnis wird in Weiterführung des erfindungsgemäßen weiteren Verfahrens die Lesespannung UL um einen Betrag ΔU erhöht bzw. vermindert, abhängig davon ob gelöscht oder programmiert worden ist. Anschließend wird wieder geprüft, ob alle Zellen gelöscht bzw. programmiert sind. Wenn dies nicht der Fall ist, hatte die vorgegebene Hochspannung Vpp bei der ersten vorgegebenen -"normalen"- Lesespannung UL bereits den richtigen Wert und dieser Wert wird, eventuell nach Erhöhung um einen Sicherheitsbetrag, im Speicher SP abgespeichert.

Wenn jedoch wieder alle Speicherzellen als gelöscht bzw. programmiert erkannt wurden, wird die Lesespannung nochmals um einen Betrag ΔU erhöht bzw. vermindert (je nachdem, ob gelöscht oder programmiert worden ist) und nochmals der Wert der Zellen gelesen und mit dem zu schreiben gewünschten Wert verglichen.

Wenn sich jetzt ergibt, daß nicht alle Zellen gelöscht bzw. programmiert sind, wird die vorgegebene Hochspannung um den Betrag ΔU, um den die Lesespannung erhöht bzw. vermindert wurde, vermindert und dieser Wert wird, eventuell um einen Sicherheitsbetrag erhöht im Speicher SP abgespeichert.

Die Lesespannung UL wird so oft um einen Betrag ΔU erhöht bzw. vermindert, bis der Test ergibt, daß zumindest eine Speicherzelle nicht gelöscht oder programmiert wurde. Die vorgegebene Hochspannung wird dann um einen Wert verringert, der dem Produkt des Betrags ΔU und der Anzahl der kompletten Schleifendurchläufe entspricht.

Im Falle, daß beim allerersten Test zumindest eine Zelle als nicht gelöscht bzw. programmiert erkannt wurde, wird die Lesespannung um einen Betrag ΔU vermindert bzw. erhöht, je nachdem, ob gelöscht oder programmiert worden ist. Die Lesespannung UL wird also in die andere Richtung verändert. Anschließend erfolgt, eventuell über mehrere Schleifendurchläufe ein Testen und sukzessives Vermindern bzw. Erhöhen der Lesespannung UL um den Betrag ΔU, bis alle Zellen als gelöscht bzw. programmiert erkannt sind. Dann wird die vorgegebene Hochspannung um einen Wert, der dem Produkt aus dem Betrag ΔU und der Anzahl der Schleifendurchläufe+1 entspricht, erhöht und dieser Wert dann (eventuell nach Erhöhung um einen Sicherheitsbetrag) wiederum im Bereich A des Speichers SP abgespeichert.

Bei den erfindungsgemäßen Verfahren können für das Löschen und Programmieren unterschiedliche Werte der Hochspannung im Speicher SP abgespeichert sein. Es kann allerdings auch nur ein Wert, nämlich der größere der beiden, gewählt werden.

Durch die erfindungsgemäßen Verfahren ist es möglich, individuell für jeden elektrisch lösch- und programmierbaren Festwerthalbleiterspeicher SP die für ihn zum Löschen oder Programmieren nötige Hochspannung Vpp zu ermitteln und im Speicher SP selbst in einem dort vorgesehenen Bereich A abzuspeichern. Von dort ist diese ermittelte Hochspannung für jeden weiteren Losch- bzw. Programmiervorgang abrufbar.

Die erfindungsgemäßen Verfahren laufen selbsttätig zumindest bei der ersten Inbetriebnahme des Speichers SP ab.

## Patentansprüche

1. Verfahren zum Ermitteln der zum Programmieren oder zum Löschen nötigen Hochspannung (Vpp) bei einem programmier- und löschbaren Festwerthalbleiterspeicher (SP) mit folgenden Schritten:
a) Anlegen einer Hochspannung (Vpp) oder - im Fall der wiederholten Durchführung dieses Schritts - der erhöhten Hochspannung an das Steuergate (SG) einer Speicherzelle zum Löschen oder an den Drainanschluß der Speicherzelle zum Programmieren der Speicherzelle,
b) Lesen der Zellen mit einer vorgegebenen Lesespannung (UL),
c) wenn alle Zellen gelöscht oder programmiert sind: nichtflüchtiges Speichern der Hochspannung,
d) wenn wenigstens eine Zelle nicht gelöscht oder programmiert ist: Erhöhen der Hochspannung um einen bestimmten Betrag (AV) und Beginn bei Schritt a).

2. Verfahren nach Anspruch 1, **dadurch gekennzeichnet**, daß vor jedem Programmieren oder Löschen der Speicherzellen mit einer eingestellten Hochspannung der Speicher mit einer maximalen Hochspannung gelöscht bzw. programmiert wird.

3. Verfahren zum Ermitteln der zum Programmieren oder Löschen nötigen Hochspannung (Vpp) bei einem programmier- und löschbaren Festwerthalbleiterspeicher (SP) mit folgenden Schritten:
a) Anlegen einer vorgegebenen Hochspannung (Vpp) an das Steuergate einer Speicherzelle zum Löschen oder an den Drainanschluß der Speicherzelle zum Programmieren der Speicherzelle,
b) Einstellen einer vorgegebenen Lesespannung (UL),
c) Lesen der Zellen bei der vorgegebenen Lesespannung (UL),
d) wenn alle Zellen gelöscht oder programmiert sind:
d1) Erhöhen bzw. Vermindern der Lesespannung um einen vorgegebenen Betrag ΔU.
d2) Lesen der Zellen bei der erhöhten bzw. verminderten Lesespannung,
d3) wenn wenigstens eine Zelle nicht gelöscht oder programmiert ist: Vermindern der vorgegebenen Hochspannung (Vpp) um den Betrag ΔU•(Anzahl der Schleifendurchläufe) und Speichern der verminderten Hochspannung,
d4) wenn alle Zellen gelöscht bzw. programmiert sind: Weitermachen mit Schritt d1),
e) wenn wenigstens eine Zelle nicht gelöscht oder programmiert ist:
e1) Vermindern bzw. Erhöhen der Lesespannung um einen vorgegebenen Betrag (ΔU),
e2) Lesen der Zellen bei der verminderten bzw. erhöhten Lesespannung,
e3) wenn alle Zellen gelöscht bzw. programmiert sind: Erhöhen der vorgegebenen Hochspannung (Vpp) um den Betrag ΔU•(Anzahl der Schleifendurchlaufe+1) und Speichern der erhöhten Hochspannung,
e4) wenn wenigstens eine Zelle nicht gelöscht bzw. programmiert ist: Weitermachen mit Schritt e1).

4. Verfahren nach Anspruch 1, 2 oder 3, **dadurch gekennzeichnet,** daß vor dem Speichern der Hochspannung diese um einen Sicherheitsbetrag erhöht wird.

5. Vorrichtung zum selbstätigen Ermitteln der zum Programmieren und/oder Löschen nötigen Hochspannung(en) (Vpp) bei einem programmier- und löschbaren Festwerthalbleiterspeicher (SP), mit folgenden Mitteln zur Durchführung eines Verfahren gemäß einem der Ansprüche 1 bis 4:
• einer Steuereinheit (ST), die mit dem Speicher (SP) über einen Adress- und Datenbus (ADB) sowie einer Leitung zum Beaufschlagen des Speichers (SP) mit einer Lesespannung (UL) verbunden ist,
• einem einstellbaren Hochspannungsgenerator (HG), der von der Steuereinheit (ST) mit einem Steuersignal (S) beaufschlagbar ist,
• wobei der Speicher (SP) von dem Hochspannungsgenerator (HG) mit einer einstellbaren Hochspannung (Vpp) beaufschlagbar ist, und
• wobei der Speicher (SP) einen Bereich (A) aufweist, in den bzw. aus dem die ermittelte(n) nötige(n) Hochspannung(en) (Vpp) einschreib- und auslesbar ist (sind).

## Claims

1. Method for determining the high voltage (Vpp) which is required for programming or for erasure in a programmable and erasable read-only semiconductor memory (SP), having the following steps:
a) application of a high voltage (Vpp) or - in the case of the repeated implementation of this step - the increased high voltage to the control gate (SG) of a memory cell for the purpose of erasing the memory cell or to the drain connection of the memory cell for the purpose of programming the memory cell,
b) reading of the cells with a predetermined read voltage (UL),
c) if all of the cells are erased or programmed: nonvolatile storage of the high voltage,
d) if at least one cell is not erased or programmed: increasing of the high voltage by a specific amount (ΔV) and beginning at step a).

2. Method according to Claim 1, characterized in that the memory is erased or programmed with a maximum high voltage before every instance of programming or erasing the memory cells with a set high voltage.

3. Method for determining the high voltage (Vpp) which is required for programming or for erasure in a programmable and erasable read-only semiconductor memory (SP), having the following steps:
a) application of a predetermined high voltage (Vpp) to the control gate of a memory cell for the purpose of erasing the memory cell or to the drain connection of the memory cell for the purpose of programming the memory cell,
b) setting of a predetermined read voltage (UL),
c) reading of the cells at the predetermined read voltage (UL),
d) if all of the cells are erased or programmed:
d1) increasing or reduction of the read voltage by a predetermined amount ΔU,
d2) reading of the cells at the increased or reduced read voltage,
d3) if at least one cell is not erased or programmed: reduction of the predetermined high voltage (Vpp) by the amount ΔU● (number of loop iterations) and storage of the reduced high voltage,
d4) if all of the cells are erased or programmed: continuation with step d1),
e) if at least one cell is not erased or programmed:
e1) reduction or increasing of the read voltage by a predetermined amount (ΔU),
e2) reading of the cells at the reduced or increased read voltage,
e3) if all of the cells are erased or programmed: increasing of the predetermined high voltage (Vpp) by the amount ΔU●(number of loop iterations+1) and storage of the increased high voltage,
e4) if at least one cell is not erased or programmed: continuation with step e1).

4. Method according to Claim 1, 2 or 3, characterized in that the high voltage is increased by a safety margin before it is stored.

5. Apparatus for automatically determining the high voltage(s) (Vpp) which is/are required for programming and/or erasure in a programmable and erasable read-only semiconductor memory (SP), having the following means for carrying out a method in accordance with one of Claims 1 to 4:
● a control unit (ST), which is connected to the memory (SP) via an address and data bus (ADB) and also to a line for applying a read voltage (UL) to the memory (SP),
● an adjustable high-voltage generator (HG), to which a control signal (S) can be applied by the control unit (ST),
● it being possible for an adjustable high voltage (Vpp) to be applied to the memory (SP) by the high-voltage generator (HG), and
● the memory (SP) having an area (A) to and from which the determined high voltage(s) (Vpp) required can be written and read.

## Revendications

1. Procédé pour déterminer la haute tension (Vpp) requise pour la programmation ou l'effaçage dans une mémoire (SP) morte à semi-conducteur pouvant être programmée et effacée, comportant les étapes suivantes :
a) application d'une haute tension (Vpp) ou - dans le cas de la mise en oeuvre réitérée de cette étape - de la haute tension augmentée à la grille (SG) de commande d'une cellule de mémoire pour l'effaçage ou à la borne de drain de la cellule de mémoire pour la programmation de la cellule de mémoire,
b) lecture des cellules à une tension (UL) de lecture prescrite,
c) si toutes les cellules sont effacées ou programmées : mise en mémoire de manière non volatile de la haute tension,
d) si au moins une cellule n'est pas effacée ou n'est pas programmée : augmentation de la haute tension d'un montant (ΔV) déterminé et on recommence à l'étape a).

2. Procédé suivant la revendication 1, caractérisé en ce que, avant chaque programmation ou effaçage des cellules de mémoire par une haute tension réglée, la mémoire est effacée ou programmée par une haute tension maximum.

3. Procédé pour déterminer la haute tension (Vpp) requise pour programmer ou effacer dans une mémoire (SP) morte à semi-conducteur pouvant être programmée et effacée, comportant les étapes suivantes:
a) application d'une haute tension (Vpp) prescrite à la grille de commande d'une cellule de mémoire pour effacer ou à la borne de drain de la cellule de mémoire pour programmer la cellule de mémoire,
b) réglage d'une tension (UL) de lecture prescrite,
c) lecture des cellules pour la tension (UL) de lecture prescrite,
d) si toutes les cellules sont effacées ou programmées :
d1) augmentation ou diminution de la tension de lecture d'un montant (ΔU) prescrit,
d2) lecture des cellules pour la tension de lecture augmentée ou réduite,
d3) si au moins une cellule n'est pas effacée ou programmée : diminution de la haute tension (Vpp) prescrite du montant ΔU• (nombre des itérations) et mise en mémoire de la haute tension réduite,
d4) si toutes les cellules sont effacées ou programmées : on continue par l'étape d1),
e) si au moins une cellule n'est pas effacée ou programmée :
e1) diminution ou augmentation de la tension de lecture d'un montant (ΔU) prescrit,
e2) lecture des cellules pour la tension de lecture diminuée ou augmentée,
e3) si toutes les cellules sont effacées ou programmées : augmentation de la haute tension (Vpp) prescrite du montant ΔU• (nombre des itérations + 1) et mise en mémoire de la haute tension augmentée,
e4) si au moins une cellule n'est pas effacée ou programmée : on continue par l'étape e1).

4. Procédé suivant la revendication 1, 2 ou 3, caractérisé en ce que, avant la mise en mémoire de la haute tension, cette haute tension est augmentée d'un montant de sécurité.

5. Dispositif pour déterminer automatiquement la haute tension (Vpp) ou les hautes tensions (Vpp) requises pour programmer et/ou effacer dans une mémoire (SP) morte à semi-conducteur pouvant être programmée et effacée, comportant les moyens suivants pour mettre en oeuvre un procédé suivant l'une des revendications 1 à 4 :
• une unité (ST) de commande, qui est reliée à la mémoire (SP) par l'intermédiaire d'un bus (ADB) de transmission d'adresses et de données, ainsi qu'à une ligne pour alimenter la mémoire (SP) en une tension (UL) de lecture,
• un générateur (HG) de haute tension réglable, qui peut être alimenté par l'unité (ST) de commande en un signal (S) de commande,
• la mémoire (SP) pouvant être alimentée par le générateur (HG) de haute tension en une haute tension (Vpp) réglable, et
• la mémoire (SP) comportant une zone (A) dans laquelle la haute tension (Vpp) requise déterminée ou les hautes tensions requises déterminées peuvent être écrites et lues.
